# EUROPÄISCHE PATENTSCHRIFT

(11) **EP 0 890 173 B1**
(45) Veröffentlichungstag und Bekanntmachung des Hinweises auf die Patenterteilung: **06.11.2002**
(21) Anmeldenummer: 97920549.9
(22) Anmeldetag: 26.03.1997
(51) Int. Cl.: G11C 7/00, G11C 11/407

(54) **SCHALTUNGSANORDNUNG MIT EINER ANZAHL VON ELEKTRONISCHEN SCHALTUNGSKOMPONENTEN**
CIRCUIT ARRANGEMENT WITH A PLURALITY OF ELECTRONIC CIRCUIT COMPONENTS
MONTAGE COMPORTANT UNE PLURALITE DE COMPOSANTS DE CIRCUIT ELECTRONIQUES

(30) Priorität: 28.03.1996 DE 19612440
(43) Veröffentlichungstag der Anmeldung: 13.01.1999
(73) Patentinhaber: Infineon Technologies AG, 81669 München (DE)
(72) Erfinder: SEDLAK, Holger, D-81541 München (DE); PFAB, Stefan, D-82049 Pullach (DE); OBERLÄNDER, Klaus, D-86157 Augsburg (DE)
(74) Vertreter: Hermann, Uwe, Dipl.-Ing.
(86) Internationale Anmeldenummer: DE9700622
(87) Internationale Veröffentlichungsnummer: WO97037353

(56) Entgegenhaltungen:
- EP-A- 0 574 094
- WO-A-82/02274
- DE-A- 4 135 767
- US-A- 4 572 946
- US-A- 4 928 266

## Beschreibung

Die Erfindung bezieht sich auf eine Schaltungsanordnung mit einer Anzahl von elektronischen Schaltungskomponenten, deren Betriebszustand vermittels eines vorbestimmten, an die jeweilige Schaltungskomponente anzulegenden Steuersignales in einen Rücksetz- bzw. Löschzustand verbringbar ist, bei dem der Dateninhalt der Schaltungskomponente einen logischen Nullwert annimmt.

Aus unterschiedlichen Gründen kann es erforderlich sein, einzelne Register oder den vollständigen Inhalt eines auf einem Mikroprozessorchip integrierten Halbleiterspeichers oder einer weiteren Schaltungskomponente zu löschen. Insbesondere bei Chipkartenanwendungen kann es als Schutz vor einem unbefugten Auslesen vertraulicher Daten wünschenswert sein, aktiv arbeitende Schutzmaßnahmen vorzusehen, um ein Auslesen geheimer Daten beispielsweise bei einem Hackerangriff auch dann zu verhindern, wenn die Taktversorgung des Mikroprozessors abgeklemmt ist. Beim Einschalten des Mikroprozessors werden sämtliche Register in der Regel mit einem definierten Wert vorbelegt, der im Laufe der Datenverarbeitung durch unterschiedliche Dateninhalte ausgetauscht wird, welche Dateninhalte unter Umständen auch vertrauliche bzw. personenbezogene Werte beinhalten können. Zur Vorbelegung der Register mit einem vorbestimmten definierten Wert sind diese üblicherweise mit einem separat vorgesehenen Reseteingang versehen. Dieser Reseteingang geht beispielsweise auf einen Schalttransistor, der den abzuspeichernden Registerwert auf ein definiertes Potential bringt. Bei einem Halbleiterspeicher vom wahlfreien Zugriff mit einer Vielzahl von Speicherzellen würde bei einem Vorsehen von separaten Reseteingängen für jede Speicherzelle der benötigte Flächenbedarf stark zunehmen. Außerdem erfordert diese Vorgehensweise eine starke Treiberleistung für den Reset des Speichers, da beispielsweise 256x8 Transistoren gleichzeitig angesteuert werden müssen. Eine solche Anordnung widerspräche neben dem Wunsch nach einer möglichst hohen Integrationsdichte eines Halbleiterspeichers auch einer möglichst einfachen und stromsparenden Ausbildung der Ansteuerschaltungen. Als aktive Schutzmaßnahme gegen einen unbefugten Zugriff auf vertrauliche Daten könnte ferner daran gedacht werden, vermittels dem Mikroprozessor sukzessive sämtliche betroffenen Speicherzellen der Halbleitereinrichtung zu adressieren und nachfolgend jede angesprochene Speicherzelle mit dem logischen Nullwert zu überschreiben. Eine solche Lösung ist jedoch nicht in allen Fällen zur Verhinderung eines unbefugten Datenzugriffs erfolgreich, da die Taktversorgung angehalten werden kann, der Mikroprozessor steht und keine Aufgaben übernehmen kann.

Aus der US-A-4 928 266 ist eine Ansteuerungsschaltung bekannt mit einer Kette von N Verzögerungselementen, dessen erstes durch ein internes Resetsignal RESET angesteuert wird, sowie einer Anzahl von N Reset-Treibern, von denen jeder durch ein Verzögerungselement angesteuert wird. Der Zweck der phasenversetzten Ansteuerung besteht darin, die durch die Auslösung des Resetsignals normalerweise verursachten Stromspitzen zu verringern.

Die EP-A-0 574 094 zeigt eine Kette von "Flash-clear"-Schaltungen, die aufeinanderfolgend zeitlich verzögert angesprochen werden, wobei die erste vermittels eines von einer Startschaltung gelieferten Startsignals aktiviert wird. Die Druckschrift zeigt weiterhin eine schaltungsmäßig vereinfachte Version der "Flash-clear"-Schaltung mit einem Ringoszillator mit einer Oszillationshaltefunktion zur Erzeugung von Taktimpulsen, die zum Setzen der Löschzeit verwendet werden, mit einem Zähler zur Zählung der Anzahl der ausgegebenen Taktimpulse des Ringoszillators, sowie einem m-Bitzähler zum Zählen der Anzahl von Speicherzellengruppen.

Die WO-A-82 022 74 A zeigt eine Anordnung zum automatischen Löschen der Dateninhalte in Datenbanken mit einem speziellen Schalter, einem "Notfallschalter", der nach Betätigung in einem ersten Schritt die Löschung sämtlicher Dateninformationen in der Datenbank und anschließend in einem zweiten Schritt die Löschung sämtlicher Programminformationen in der Datenbank steuert. Diese spezielle Schaltungsanordnung dient in erster Linie dazu, eine Datenbank vor dem unbefugten Zugriff oder Sabotage zu löschen, ohne sie physikalisch zu vernichten. Die Schaltungsanordnung besitzt ein vom Notfallknopf betätigbares bistabiles Flipflop, dessen Ausgangssignal die durch den Systemtakt gesteuerten Adressgeneratoren aktivieren, d.h. es werden sämtliche Adressen generiert, die in den verbundenen Datenspeichern auftreten können. Die Adressgeneratoren arbeiten parallel zueinander.

Die DE-A-41 35 767 zeigt eine Vorrichtung zum Sichern von Daten gegen unbefugten Zugriff in einer Steuereinheit eines münzbetätigten Automaten. Bei einem Versuch, das die Steuereinheit schützende Gehäuse zu öffnen, wird dieser Vorgang durch Sensoren erkannt. Die Sensoren, die einen mechanischen, oder chemischen Angriff, sowie eine Veränderung der Umgebungstemperatur sowie der Betriebsspannung erfassen, sind mit einer Sensorik verbunden, die eine eigene Stromversorgung umfaßt. Von einer Löschschaltung werden bei einem Angriff auf die Steuereinheit die Daten in den datenrelevanten Bauteilen gelöscht.

Der Erfindung liegt die Aufgabe zugrunde, eine Schaltungsanordnung der eingangs angegebenen Gattung zur Verfügung zu stellen, vermittels welcher auch unabhängig von der externen Taktversorgung eine selbsttätig erfolgende Rücksetzung der Dateninhalte von ausgewählten Schaltungskomponenten auf den logischen Nullwert aktivierbar ist, ohne den Flächenbedarf oder den schaltungstechnischen Aufwand der Schaltungsanordnung wesentlich zu vergrößern.

Diese Aufgabe wird durch eine Schaltungsanordnung nach Anspruch 1 gelöst.

Nach der Erfindung ist insbesondere vorgesehen:
- die Schaltungskomponenten umfassen zum Einen Register und/oder Schaltungselemente und zum Anderen Speicherelemente,
- den Registern bzw. Schaltungselementen ist eine erste Ansteuerschaltung mit Öffnungsstufen und den Speicherelementen ist eine der ersten Ansteuerschaltung nachgeschaltete zweite Ansteuerschaltung mit Öffnungsstufen zugeordnet,
- zur Löschung der Speicherelemente ist ein Datenbus vorgesehen, auf welchem ein Datensignal zum Einschreiben eines Dateninhalts in die Speicherelemente zur Verfügung gestellt ist, wobei nach Aktivierung der zweiten Ansteuerschaltung vermittels der vorgeschalteten Öffnungsstufe der ersten Ansteuerschaltung ein auf dem Datenbus anliegender logischer Nullwert in die Speicherelemente eingeschrieben und auf diese Weise die Speicherelemente in den Löschzustand verbracht werden.

Der Erfindung liegt hierbei die Erkenntnis zugrunde, zur Löschung der Dateninhalte von einzelnen Schaltungskomponenten wie beispielsweise Registern oder Speicherzellen von Halbleiterspeichern eine selbsttätig aktivierbare Ansteuerschaltung vorzusehen, die in Analogie zur bekannten mechanischen Dominokette arbeitet. Einmal angestoßen, arbeitet die Ansteuerschaltung gemäß Erfindung separat und völlig unabhängig von der externen Taktversorgung einer Steuerschaltung wie beispielsweise eines Mikrocontrollers, welcher bei einem unbefugten Zugriff gestoppt werden kann, so daß gewissermaßen in aller Ruhe ein Auslesen vertraulicher Dateninhalte insbesondere aus dem besonders risikobehafteten statischen Halbleiterspeicher möglich ist. Nach Erfassung eines geeigneten Auslösesignals, welches beispielsweise nach Detektion einer unzulässigen Abweichung von dem erlaubten Betriebszustand der Steuerschaltung oder einer Schaltungskomponente erfolgt, wird ein Freigabesignal gesetzt, welches gewissermaßen die elektronische Dominokette, sprich Ansteuerschaltung anstößt. Als Reaktion auf die Auslösung des Freigabesignals wird über eine erste Öffnungsstufe, welches durch. ein Öffnungssignal betätigt wird, eine erste Schaltungskomponente aus einer Vielzahl ausgewählter Schaltungskomponenten der Schaltungsanordnung, die entsprechend gelöscht werden sollen, beispielsweise ein Akkumulator oder ein Register des Mikrocontrollers, im Sinne einer Rucksetzung bzw. Löschung betätigt, und zeitlich anschließend, nachdem die erste öffnungsstufe betätigt worden ist, wird ein weiteres, zweites Öffnungssignal erzeugt, welches eine weitere Öffnungsstufe auslöst, beispielsweise zur Aktivierung eines Adressdekoders und nachfolgenden Löschung einer Gruppe von adressierten Speicherzellen eines statischen Halbleiterspeichers. Diesem Vorgang schließen sich weitere Öffnungssignale entsprechend der gewünschten Anzahl anzusteuernder Schaltungskomponenten an.

Bei einer bevorzugten Ausführung der Erfindung kann vorgesehen sein, daß jeder Schaltungskomponente jeweils eine einzige Öffnungsstufe der Ansteuerschaltung zugeordnet ist.

Bei einer bevorzugten Ausführung der erfindungsgemäßen Schaltungsanordnung ist ein Adressbus zur Adressierung einer Schaltungskomponente sowie ein Datenbus vorgesehen, auf welchem ein Datensignal zum Einschreiben eines Dateninhalts in eine Schaltungskomponente zur Verfügung gestellt wird. Nach Öffnung einer Schaltungskomponente vermittels der zugeordneten Öffnungsstufe der Ansteuerschaltung wird beispielsweise ein auf dem Datenbus anliegender logischer Nullwert in die Schaltungskomponente eingeschrieben, so daß die Schaltungskomponente auf diese Weise in den Löschzustand verbracht wird. Bei einer besonders bevorzugten Ausführung liegen beispielsweise auf sämtlichen Leitungen des Datenbusses logische Nullwerte an; durch die Ansteuerschaltung werden die einzelnen Schaltungskomponenten, die mit dem Datenbus verbunden sind, zeitlich nacheinander geöffnet und als Reaktion auf die Öffnung zeitlich nacheinander die logischen Nullwerte auf dem Datenbus in die einzelnen Schaltungskomponenten eingeschrieben. Gegenüber der im Stand der Technik bekanntgewordenen Maßnahme, bei der jede Schaltungskomponente bzw. jede Speicherzelle einen flächenaufwendigen Reset-Transistor zur Vorlage eines ausreichend großen Reset-Signales erfordert, besitzt die erfindungsgemäße Schaltungsanordnung den Vorteil eines weitaus geringeren Flächenbedarfes. Gegenüber einer weiteren im Stand der Technik bisher verwendeten Maßnahme, bei der der Adressdekoder mit einer Zusatzschaltung versehen ist, welche eine gleichzeitige Öffnung sämtlicher Speicherzellen ermöglicht, und bei der somit eine ausreichend starke Treiberleistung des Datenbusses erforderlich ist, um sämtliche Speicherzellen gleichzeitig auf den logischen Wert Null zu ziehen, besitzt die erfindungsgemäße Schaltungsanordnung den Vorteil, daß der Datenbus eine wesentlich geringere Treiberleistung aufbringen muß, da die Schaltungskomponenten bzw. Speicherzellen nicht zeitgleich, sondern nacheinander angesprochen werden.

Bei einer weiterhin bevorzugten Ausführung der Erfindung mit einer besonders einfachen schaltungstechnischen Realisierung der Ansteuerschaltung ist vorgesehen, daß das von der letzten Öffnungsstufe der zweiten Ansteuerschaltung ausgegebene Öffnungssignal in einer Rückkopplungsschleife an den Eingang der ersten Öffnungsstufe der zweiten Ansteuerschaltung zurückgeführt ist.

Bei einer besonders bevorzugten Ausführung der Erfindung ist vorgesehen, daß die Schaltungskomponenten Speicherzellen eines Registers und/oder eines programmierbaren Haibleiterspeichers darstellen. Hierbei ist von Vorteil vorgesehen, daß die den Speicherzellen des Registers zugeordneten Öffnungsstufen vor den Öffnungsstufen geschaltet sind, die den Speicherzellen des programmierbaren Halbleiterspeichers zugeordnet sind. Nach Auslösung der Ansteuerschaltung vermittels des Freigabesignals werden somit zunächst die Register und daran anschließend die Speicherzellen des Halbleiterspeichers geöffnet. Die Register unterstützen hierbei die Treiberleistung des Datenbusses. Eine solche Reihenfolge der Öffnungsstufen ist auch deswegen von Vorteil, da es bei der Ansteuerung von Speicherzellen eines dynamischen Halbleiterspeichers vom wahlfreien Zugriff (RAM) lediglich durch einen zusätzlichen Schaltungsaufwand möglich ist zu erkennen, wann die einzelnen Öffnungsstufen der Ansteuerschaltung vollständig durchgelaufen sind; wegen der Abhängigkeit der Adressierung der Speicherzelle oder der Gruppe von Speicherzellen von der jeweils vorherigen Adresse kann eine eindeutige Zuordnung darüber nicht getroffen werden, welches die "erste" oder "letzte" anzusteuernde Gruppe tatsächlich ist.

Ein weiterer Vorteil der erfindungsgemäßen Schaltungsanordnung in Analogie zur mechanischen Dominokette besteht darin, daß für die zeitlich aufeinanderfolgende Ansteuerung der einzelnen Öffnungsstufen nur jeweils ein Inverter einer Öffnungsstufe erforderlich ist, und darüber hinaus jede vorhergehende Öffnungsstufe die jeweils nachfolgende betätigt bzw. treibt.

Bei einer besonders bevorzugten Ausführung der Erfindung ist vorgesehen, daß die Auslösung der Ansteuerschaltung durch die Eingabe eines Freigabesignales an die erste öffnungsstufe selbsttätig erfolgt. Hierbei kann von Vorteil eine der Ansteuerschaltung vorgeschaltete Sensorschaltung vorgesehen sein, die der in der Schaltungsanordnung vorgesehenen Steuerschaltung zur elektronischen Steuerung einer oder mehrerer Schaltungskomponenten zugeordnet ist, und eine Abweichung vom. erlaubten Betriebszustand der Steuerschaltung oder einer Schaltungskomponente erfaßt und als Reaktion auf eine Abweichung des erlaubten Betriebszustandes das Freigabesignal an die erste Öffnungsstufe zur selbsttätigen Aktivierung der Ansteuerschaltung ausgibt. Bei einer schaltungstechnisch einfachen Realisierung kann hierbei vorgesehen sein, daß die Sensorschaltung der Taktversorgung und/oder der Spannungsversorgung der Steuerschaltung oder einer Schaltungskomponente zugeordnet ist und eine Abweichung der Versorgungsspannung von der Betriebsspannung und/oder eine Abweichung des Versorgungstaktes von dem Betriebstakt erfaßt und bei Vorliegen einer Abweichung der Betriebsspannung und/oder des Betriebstaktes das Freigabesignal erzeugt und zur selbsttätigen Auslösung bzw. Aktivierung der Ansteuerschaltung an die erste Öffnungsstufe ausgibt. Hierbei kann die Sensorschaltung eine Spannungsdetektorschaltung aufweisen, welche ein Über- bzw. Unterschreiten der Versorgungsspannung von den vorbestimmten oberen bzw. unteren Grenzwerten der Betriebsspannung erfaßt. Andererseits kann die Sensorschaltung auch eine Frequenzdetektorschaltung aufweisen, die ein Über- bzw. Unterschreiten des Versorgungstaktes von den oberen bzw. unteren Grenzwerten des Betriebstaktes erfaßt. Ein unbefugter Zugriff auf vertrauliche Daten kann auf diese Weise beispielsweise bei Vorliegen einer zu hohen oder zu niedrigen Betriebsspannung, oder bei Vorliegen einer zu niedrigen oder zu hohen Taktrate erkannt und zur automatischen Auslösung der Ansteuerschaltung verwendet werden.

Um sicherzustellen, daß unter allem Umständen die erforderliche Treiberstärke des Datenbusses ausreicht, um die Dateninhalte der anzusteuernden Schaltungskomponenten sukzessive umzukippen, kann vermittels einer Regelung das Fortschreiten des Öffnens der anzusprechenden Schaltungskomponenten bei zu schwacher Treiberleistung des Datenbusses gestoppt werden. Von Vorteil ist bei einer bevorzugten Ausführungsform der Erfindung daher eine der Ansteuerschaltung zugeordnete Regelschaltung vorgesehen, die bei einer Fehlfunktion des Datenbusses bzw. des Datentreibers eine erneute Aktivierung der Ansteuerschaltung steuert. Erst nach Erreichen eines stabilen Zustandes wird mit der sukzessiven Rücksetzung der Dateninhalte von samtlichen Schaltungskomponenten fortgefahren, d.h. die Ansteuerschaltung wird gestoppt und anschließend erneut aktiviert. Bei einer einfachen schaltungstechnischen Realisierung kann hierbei vorgesehen sein, daß die Regelschaltung die Datensignale des Datenbusses abgreift und eine Abweichung vom Nullwert für ein kurzzeitiges Abschalten und anschließend zur erneuten selbsttätigen Aktivierung der Ansteuerschaltung erfaßt.

Bei einer besonders bevorzugten Ausführung ist vorgesehen, daß wenigstens eine der Schaltungskomponenten eine auf einem Halbleitersubstrat ausgebildete Halbleiterspeichervorrichtung vom wahlfreien Zugriffstyp mit einer Vielzahl von Speicherzellen darstellt, die vermittels einer Adressierungsschaltung zum beliebig oftmalig erfolgenden Einschreiben und Auslesen von an einer Datenein- bzw. ausgabeschaltung anliegenden Dateninhalten adressierbar sind, und die der Halbleiterspeichervorrichtung zugeordnete Öffnungsstufe der Ansteuerschaltung unmittelbar auf die Adressierungsschaltung zur Adressierung wenigstens einer Speicherzelle wirkt, wobei die Datenein- bzw. ausgabeschaltung zur Ausgabe eines Nullwertes an die adressierte Speicherzelle gesteuert ist. Hierbei kann wenigstens ein Teil der Schaltungskomponenten einer Gruppe von Speicherzellen der Halbleiterspeichervorrichtung zugeordnet sein, die vermittels der Ansteuerschaltung zur Rücksetzung der Dateninhalte der Speicherzellen auf den logischen Nullwert zeitlich nacheinander selbsttätig adressiert werden. Aufgrund des vorhandenen Dekodierschemas einer gängigen Halbleiterspeichervorrichtung vom wahlfreien Zugriff wird die sukzessive Adressierung der Speicherzellen vermittels der Öffnungsstufen der erfindungsgemäßen Ansteuerschaltung sehr einfach. Bei bestehenden Halbleiterspeichervorrichtungen vom wahlfreien Zugriffstyp ist es aufgrund der erfindungsgemäßen Schaltungsanordnung nicht erforderlich, zusätzliche, unter Umständen schaltungstechnisch komplizierte Logikbestandteile aufzubauen. Zur Ansteuerung bzw. Rücksetzung der Speicherzellen der Halbleiterspeichervorrichtung vom wahlfreien Zugriffstyp genügt eine für alle Speicherzellen gemeinsame Ansteuerschaltung mit einer entsprechenden Anzahl von Öffnungsstufen. Erst nachdem eine erste Zellgruppe adressiert wurde, d.h. die entsprechenden Wortleitungen der Speicherzellen sind im aktiven Zustand, wird eine nächste Zellgruppe der Halbleiterspeichervorrichtung vom wahlfreien Zugriffstyp adressiert. Hierdurch wird auch sichergestellt, daß die kapazitive Belastung des Datenbusses begrenzt wird. Würden demgegenüber sämtliche Register und Speicherzellen einer Halbleiterspeichervorrichtung gleichzeitig geöffnet werden, müßte der Datenbus eine wesentlich höhere Treiberfähigkeit besitzen, um im ungünstigsten Fall sämtliche Speicherzellen der Halbleiterspeichervorrichtung schnell umkippen zu können.

Bei einer besonders bevorzugten Anwendung der erfindungsgemäßen Schaltungsanordnung bezieht sich diese auf den innerhalb eines Kartenkörpers einer elektronischen Chipkarte untergebrachten Halbleiterchip, welcher neben dem Halbleiterspeicher vom wahlfreien Zugriffstyp als weitere Funktionseinheiten insbesondere einen Festwert-Halbleiterspeicher und/oder einen elektrisch löschbaren Halbleiterspeicher umfaßt.

Weitere Merkmale, Vorteile und Zweckmäßigkeiten der Erfindung ergeben sich aus der Beschreibung eines Ausführungsbeispieles anhand der Zeichnung. Es zeigt:
- Figur 1: ein schematisches Schaltbild der Schaltungsanordnung mit einer Ansteuerschaltung gemäß einem Ausführungsbeispiel der Erfindung; und
- Figur 2: ein schematisches Schaltbild einer der Ansteuerschaltung nach Figur 1 zugeordneten Regelschaltung.

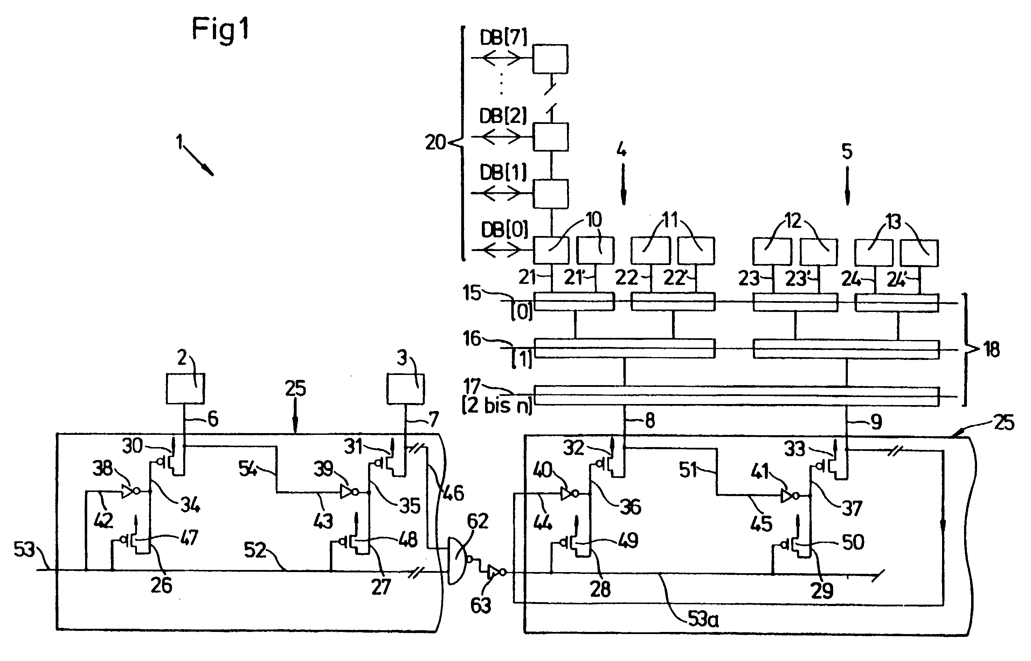

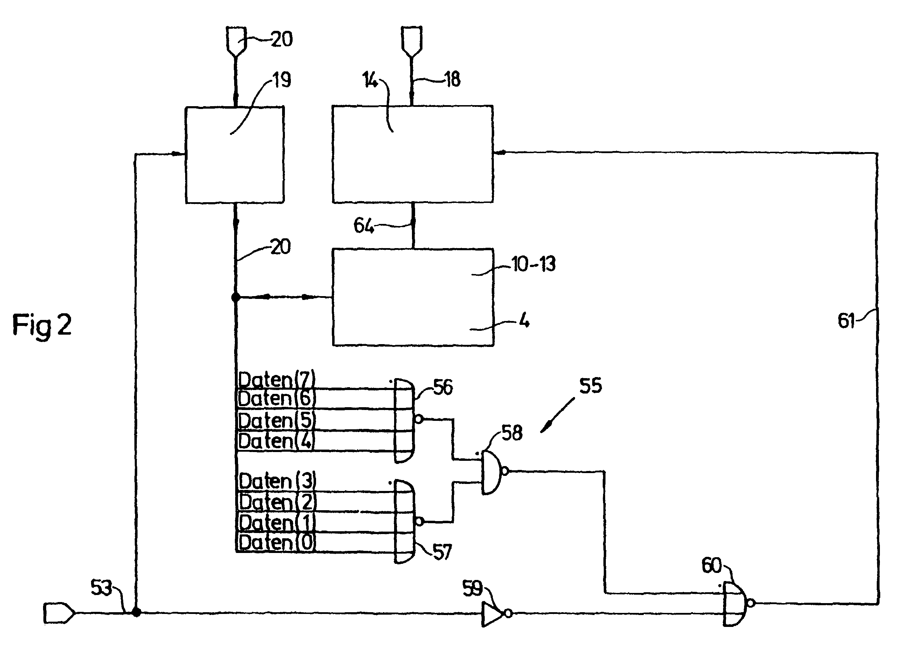

Das in den Figuren 1 und 2 dargestellte Ausführungsbeispiel einer erfindungsgemäßen Schaltungsanordnung 1 besitzt eine Anzahl von elektronischen Schaltungskomponenten 2, 3, 4 und 5, deren Betriebszustand vermittels eines vorbestimmten, an die jeweilige Schaltungskomponente 2 bis 5 anzulegenden Steuersignales 6, 7, 8 und 9 in einen Rücksetz- bzw. Löschzustand ansteuerbar ist, bei dem der Dateninhalt der jeweiligen Schaltungskomponente 2 bis 5 einen logischen Nullwert annimmt. Die Schaltungskomponente 4 umfaßt eine auf einem Halbleitersubstrat ausgebildete Halbleiterspeichervorrichtung vom wahlfreien Zugriffstyp (statisches RAM) mit einer ersten Gruppe von Speicherzellen 10 und 11. Die Schaltungskomponente 5 umfaßt eine auf dem gleichen Halbleitersubstrat ausgebildete Halbleiterspeichervorrichtung vom wahlfreien Zugriffstyp (statisches RAM) mit einer zweiten Gruppe von Speicherzellen 12 und 13. Die Speicherzellen 10 bis 13 sind vermittels einer Adressierungsschaltung 14 in der Form eines an sich bekannten Adressdekoders, der mit Adressleitungen 15 (Adressbit Null), 16 (Adressbit Eins) und weiteren Adressleitungen 17 (Adressbit Zwei bis n) eines Adressbusses 18 ansteuerbar ist, zum beliebig oftmalig erfolgenden Einschreiben und Auslesen von an einem Datenbus 20 mit 8 Datenleitungen DB [0] bis DB [7] anliegenden 8-Bit-Daten einer Datenein- bzw. -ausgabeschaltung 19 adressierbar, wie dies an sich dem Fachmann geläufig ist und daher an dieser Stelle im einzelnen nicht näher erläutert zu werden braucht. Die Schaltungskomponente 2 stellt beispielsweise ein Register zum zeitweisen Abspeichern von Daten dar, die Schaltungskomponente 3 stellt beispielhaft einen ebenfalls zum zeitweisen Abspeichern von Daten dienenden Akkumulator dar, wobei das Register 2 und der Akkumulator 3 einem ebenfalls auf dem Halbleitersubstrat integriert ausgebildeten Mikroprozessor (Steuerschaltung) zugeordnet sind, welcher Mikroprozessor der Übersichtlichkeit halber in den Figuren 1 und 2 nicht näher dargestellt ist. Die Adressdekodierung der Speicherzellen 10 bis 13 erfolgt mittels 8 Wortselektleitungen 21, 21', 22, 22', 23, 23', 24, 24', die jeweils mit dem Adressdekoder 14 elektrisch gekoppelt sind. Neben den in Figur 1 dargestellten Schaltungskomponenten 2 bis 5 können an sich beliebig weitere Schaltungskomponenten vorgesehen sein, die ebenfalls durch ein Steuersignal in einen Rücksetz- bzw. Löschzustand ansteuerbar sind, bei dem der Dateninhalt einen logischen Nullwert annimmt.

Erfindungsgemäß ist zur Ansteuerung der Rücksetzung der Dateninhalte von sämtlichen Schaltungskomponenten auf den logischen Nullwert eine selbsttätig aktivierbare Ansteuerschaltung 25, 25a mit einer der Anzahl der anzusteuernden Schaltungskomponenten entsprechenden Anzahl von in Reihe nacheinander geschalteten Öffnungsstufen 26, 27, 28, 29 vorgesehen, wobei jeder Schaltungskomponente 2 bis 5 jeweils eine Öffnungsstufe 26 bis 29 der Ansteuerschaltung 25 bzw. 25a zugeordnet ist. Jede Öffnungsstufe umfaßt einen Gatterschaltkreis bestehend aus einem Schalttransistor 30, 31, 32, 33, und jeweils einen den Steueranschluß 34, 35, 36, 37 der Schalttransistoren 30 bis 33 anzusteuernden Treiber 38, 39, 40, 41, an dessen Eingang jeweils ein Treibersignal 42, 43, 44, 45 anliegt. Bei einem Pegelwert des Treibersignales von logisch "Eins" wird der entsprechend angesteuerte Schalttransistor 30 bis 33 geöffnet, während bei einem Pegel von logisch "Null" der entsprechende Schalttransistor sperrt. Jede Öffnurgsstufe 26 bis 29 umfaßt ferner einen Freigabeschalter 47, 48, 49, 50, der über ein an einer Freigabesignalleitung 52 anliegendes Freigabesignal 53 eingeschaltet wird, sofern das Freigabesignal den Pegel logisch "Null" besitzt, und ansonsten bei einem Pegel von logisch "Eins" des Freigabesignals 53 sperrt. Zur Aktivierung der Ansteuerschaltung 25 im Sinne einer zeitlich nacheinander erfolgenden Ansteuerung zur Rücksetzung der Dateninhalte von sämtlichen Schaltungskomponenten 2 bis 5 auf den logischen Nullwert wird das Freigabesignal auf den Pegel logisch "Eins" gesetzt. Bei einem Zustand des Freigabesignals 53 auf dem Pegel von logisch "Null" ist die Ansteuerschaltung 25 deaktiviert.

Die Ansteuerschaltung 25 nach dem Ausführungsbeispiel arbeitet wie folgt. Zur Aktivierung der Ansteuerschaltung 25 wird das Freigabesignal 53 ausgelöst, d.h. der Pegel des Freigabesignals 53 wird von logisch "Null" auf den Pegel logisch "Eins" gesetzt, und es öffnet der Schalttransistor 30 der ersten Öffnungsstufe 26 zur Ansteuerung der Schaltungskomponente 2. Über das vom Schalttransistor 30 ausgegebene Öffnungssignal 6 wird das Register 4 angesprochen und eine Rücksetzung bzw. Löschung des Dateninhalts auf den logischen Wert Null gesteuert. Dem schließt sich die Ausgabe eines Treibersignals 43 auf der Leitung 54 an, vermittels welchem die zweite Öffnungsstufe 27 der Ansteuerschaltung 25 aktiviert, und der Dateninhalt der von der zweiten Öffnungsstufe 27 angesprochenen Schaltungskomponente 5 gelöscht wird. Die zweite Öffnungsstufe 27 gibt danach ein Treibersignal 44 auf der Leitung 46 über ein Nandgatter 62 und einen Inverter 63 an die dritte Öffnungsstufe 28 aus, durch welches der Schalttransistor 32 geöffnet wird und ein Öffnungssignal 8 zur Ansteuerung der Schaltungskomponente 4 ausgegeben wird. Das Nandgatter 62 mit dem nachgeschalteten Inverter 63 ermöglicht den Start der Ansteuerschaltung an einer beliebigen Stelle der jeweiligen Öffnungsstufe entsprechend der anzusteuernden RAM-Speicherzellen, wobei die Signale 46 und 53 an den Eingängen des Nandgatters 62 auf logisch "Eins" liegen. Im einzelnen wird hierzu der Adressdekoder 14 zur Ansteuerung der Speicherzellen 10, 11 angesprochen, und jeweils einen logische "Null", die auf den Datenleitungen DB [0] bis DB [7] des Datenbusses 20 liegen, in die vom Adressdekoder 14 ausgewählten Speicherzellen 10 und 11 eingeschrieben. Der Dateninhalt der Speicherzellen 10 und 11 wird somit automatisch mit den auf dem Datenbus 20 anliegenden Nullwerten überschrieben, was einer Löschung des Speicherinhalts der Speicherzellen entspricht. Danach wird über die Leitung 51 an den Treiber 41 der nachfolgenden vierten Öffnungsstufe 29 ein weiteres Treibersignal 45 angelegt, welches den Schalttransistor 33 der vierten Öffnungsstufe 29 zur Ausgabe eines Steuersignales 9 öffnet. Das Steuersignal 9 dient wiederum zur Ansteuerung bzw. Auswahl der Speicherzellen 12 und 13 der vierten Schaltungskomponente 5 vermittels dem Adressdekoder 14, worauf die Dateninhalte der Speicherzellen 12 und 13 mit dem auf dem Datenbus 20 anliegenden Nullwert überschrieben werden. Auf diese Weise werden sämtliche RAM-Speicherzellen 10, 11, 12, 13 der Schaltungskomponenten 4 und 5 automatisch in Gruppen nacheinander adressiert und mit dem Wert logisch "Null" auf dem Datenbus 20 überschrieben. Die zeitlich aufeinanderfolgende Adressierung der Speicherzellen 10 bis 13 kann durch das hierarchisch gegliederte Dekodierschema des RAM-Speichers vermittels der erfindungsgemäßen Ansteuerschaltung 25 auf einfache Weise erfolgen, so daß lediglich einige zusätzliche, schaltungstechnisch einfach zu realisierende Logikschaltkreise vorzusehen sind. Erst nachdem die Gruppe der Speicherzellen 10 und 11 adressiert wurde, d.h. die entsprechenden Wortleitungen befinden sich im aktiven Zustand, wird die nächste Gruppe der Speicherzellen 12 und 13 des RAM-Speichers adressiert. Auf diese Weise wird sichergestellt, daß die kapazitive Belastung des Datenbusses 20 begrenzt wird. Würden demgegenüber alle Speicherzellen 10 bis 13 des RAM-Speichers gleichzeitig geöffnet werden, müßte der Datenbus 20 eine wesentlich größere Treiberfähigkeit besitzen, um im ungünstigsten Fall sämtliche Speicherzellen des RAM-Speichers schnell auf den logischen Wert "Null" umkippen zu können. Der Datenbus 20 wird unmittelbar nach dem auslösenden Löschvorgang auf einen definierten Wert gebracht, beispielsweise werden sämtliche Datenleitungen des Datenbusses auf den Pegel logisch "Null" gesetzt.

Das am Ende der Ansteuerschaltung 25 von der letzter. Öffnungsstufe 29 ausgegebene Treibersignal ist wiederum an den Eingang der Öffnungsstufe 28 zurückgeführt.

In Figur 2 sind nähere Einzelheiten einer der Ansteuerschaltung 25a zugeordneten Regelschaltung 55 dargestellt, welche bei einer Fehlfunktion eine erneute Aktivierung der Ansteuerschaltung 25 steuert, für den Fall, daß - etwa bei einer zu kurz eingestellten Laufzeit - die Treiberleistung des Datenbusses 20 nicht ausreichen sollte, ein Register bzw. eine RAM-Speicherzelle auf den logischen Wert "Null" zu treiben, so daß die Schaltung, die den Datenbus treibt, nicht die benotigte Treiberleistung besitzt, d.h. trotz Weiterlaufen der Ansteuerung der Schaltungskomponenten durch die Treiberschaltung 19 "falsche" - von Null verschiedene - Werte auf dem Datenbus in die Speicherzellen eingeschrieben werden. Die Regelschaltung 55 sorgt in diesem Fall dafür, daß das Freigabesignal 53 zur Auslösung der Ansteuerschaltung 25 nochmals kurzzeitig auf den Pegel logisch "Null", anschließend auf logisch "Eins" gesetzt wird, und ein definierter Neubeginn der Dominokette gestartet wird. Die zu diesem Zweck vorgesehene Regelschaltung 55 umfaßt Norgatter 56, 57, an dessen Eingängen die Leitungen des Datenbusses 20 anliegen, ein Nandgatter 58, dessen Eingänge mit den Ausgängen der Norgatter 56 und 57 gekoppelt sind, einen Inverter 59, an dem eingangsseitig das Freigabesignal 53 anliegt, und ein Norgatter 60, dessen Eingänge mit dem Ausgang des Inverters 59 und dem Ausgang des Nandgatters 58 gekoppelt ist, und dessen Ausgang über eine Leitung 61 mit dem Adressdekoder 14 gekoppelt ist. Das Bezugszeichen 64 bezeichnet wiederum Leitungen, auf denen die Öffnungssignale für die Register 2 und 3 liegen, bzw. die Wortselektleitungen für die RAM-Speicherzellen 10 bis 13. Nach Aktivierung der Ansteuerschaltung 25, d.h. das Freigabesignal 53 steht auf logisch "Eins", werden sämtliche Leitungen des Datenbusses 20 auf logisch "Null" getrieben. Sollte aufgrund eines bestimmten Umstandes die erforderliche Treiberstärke des Datenbusses 20 nicht ausreichen, um die Speicherzellen 10 bis 13 des RAM-Speichers sukzessive umzukippen, wird vermittels der Regelschaltung 55 ein Fortschreiten des Öffnens bzw. Rücksetzens der Speicherzellen bei zu schwacher Treiberleistung des Datenbusses gestoppt, und mit der sukzessiven Adressierung erst dann fortgefahren, wenn der Pegel des Datenbusses 20 wieder stabile Werte logisch "Null" annimmt. Am Ausgang des Nandgatters 58 wird auf diese Weise ein logischer Wert "Eins" ausgegeben, wenn nur eine Leitung des Datenbusses 20 den Wert logisch "Eins" annimmt. Damit wird am Ausgang des Norgatters 60 ein Signal mit dem Wert logisch "Null" erzeugt und über die Leitung 61 die Ansteuerschaltung 25 kurzzeitig ausgeschaltet, bis der Datenbus 20 wieder auf dem Wert logisch "Null" ist. Somit wird nach einer gewissen vorbestimmten Zeitdauer die Ansteuerschaltung 25 selbsttätig wieder in Gang gesetzt, wobei das am Eingang des Inverters 59 und am Eingang der Datenein- bzw. -ausgabeschaltung 19 anliegende Freigabesignal 53 noch auf dem Wert logisch "Eins" steht.

## Patentansprüche

1. Schaltungsanordnung mit einer Anzahl von elektronischen Schaltungskomponenten (2, 3, 4, 5), deren Betriebszustand vermittels eines vorbestimmten, an die jeweilige Schaltungskomponente (2, 3, 4, 5) anzulegenden Steuer- oder Datensignales (6, 7, 8, 9) in einen Löschzustand verbringbar ist, bei dem der Dateninhalt der Schaltungskomponente (2, 3, 4, 5) einen logischen Nullwert annimmt, wobei
zur zeitlich nacheinander erfolgenden Ansteuerung von sämtlichen Schaltungskomponenten (2, 3, 4, 5) eine nach Auslösung selbsttätig arbeitende Ansteuerschaltung (25) mit einer der Anzahl der Schaltungskomponenten (2, 3, 4, 5) entsprechenden Anzahl von in Reihe nacheinander geschalteten Öffnungsstufen (26, 27, 28, 29) vorgesehen ist, jede Öffnungsstufe (26, 27, 28, 29) durch ein von der unmittelbar vorhergehend angeordneten Öffnungsstufe (26, 27, 28, 29) erzeugtes Öffnungssignal (42, 43, 44, 45) zur Ausgabe eines Steuersignales an die zugehörige Schaltungskomponente aktivierbar bzw. treibbar ist, und die Öffnungsstufe (26, 27, 28, 29) nach erfolgter Ansteuerung der zugehörenden Schaltungskomponente (2, 3, 4, 5) ihrerseits ein Öffnungssignal (42, 43, 44, 45) zur Ansteuerung bzw. Aktivierung der unmittelbar nachfolgend angeordneten Öffnungsstufe (26, 27, 28, 29) ausgibt,
**dadurch gekennzeichnet, daß**
jede Öffnungsstufe einen Gatterschaltkreis umfaßt, bestehend aus
einem Freigabeschalter (47, 48, 49, 50), der über ein an einer Freigabesignalleitung (52) anliegendes Freigabesignal ausgeschaltet wird, sofern das Freigabesignal den Pegel logisch "Eins" besitzt, und bei einem Pegel von logisch "Null" des Freigabesignals leitet,
einem Schalttransistor (30, 31, 32, 33) mit einem jeweiligen Steueranschluß (34, 35, 36, 37), der mit dem Freigabeschalter verbunden ist, und
einem den Steueranschluß des Schalttransistors ansteuernden Treiber (38, 39, 40, 41), der bei einem Treibersignal von logisch "Eins" an einem Eingang des Treibers den Schalttransistor zur Ansteuerung der betreffenden Schaltungskomponente (2, 3, 4, 5) öffnet und bei einem Treibersignal von logisch "Null" an dem Eingang des Treibers den Schalttransistor sperrt, und
von dem Schalttransistor, wenn er geöffnet wird, ein Öffnungssignal ausgegeben wird, mit dem eine Rücksetzung bzw. Löschung des Dateninhalts der Schaltungskomponente auf den logischen Wert "Null" gesteuert wird, und anschließend ein Treibersignal an den Eingang des Treibers der nachfolgend angeordneten Öffnungsstufe ausgegeben wird, vermittels welchem diese Öffnungsstufe aktiviert wird.

2. Schaltungsanordnung nach Anspruch 1, bei der
die elektronischen Schaltungskomponenten (2, 3, 4, 5) je eine auf einem Halbleitersubstrat ausgebildete Halbleiterspeichervorrichtung vom wahlfreien Zugriffstyp mit einer Gruppe von Speicherzellen umfassen,
ein Datenbus (20) mit Datenleitungen (DB [0], DB [1], DB [2], DB [3], DB [4], DB [5], DB [6], DB [7]) vorhanden ist,
ein Adressdekoder (14) zur Ansteuerung der Speicherzellen zum beliebig oftmalig erfolgenden Einschreiben und Auslesen von an dem Datenbus anliegenden 8-Bit-Daten (Daten(0), Daten(1), Daten(2), Daten(3), Daten(4), Daten(5), Daten(6), Daten(7)) einer Datenein- bzw. -ausgabeschaltung (19) vorhanden ist und eine Regelschaltung (55) vorhanden ist, die aufweist Norgatter (56, 57) mit Eingängen und Ausgängen, an deren Eingängen die Datenleitungen des Datenbusses (20) anliegen,
ein Nandgatter (58) mit Eingängen und einem Ausgang, dessen Eingänge mit den Ausgängen der Norgatter (56, 57) gekoppelt sind,
einen Inverter (59), an dem eingangsseitig das Freigabesignal anliegt, und
ein weiteres Norgatter (60) mit Eingängen und einem Ausgang, dessen Eingänge mit dem Ausgang des Inverters (59) und dem Ausgang des Nandgatters (58) gekoppelt sind und dessen Ausgang über eine Leitung (61) mit dem Adressdekoder (14) gekoppelt ist, so daß die Ansteuerschaltung (25) kurzzeitig ausgeschaltet wird, wenn eine Datenleitung des Datenbusses (20) den Wert logisch "Eins" annimmt und somit am Ausgang des weiteren Norgatters (60) ein Signal mit dem Wert logisch "Null" erzeugt wird.

3. Schaltungsanordnung nach Anspruch 1 oder 2, bei der eine einer in der Schaltungsanordnung (1)
vorgesehenen Steuerschaltung zur elektronischen Steuerung einer oder mehrerer Schaltungskomponenten (2, 3, 4, 5) zugeordnete und der Ansteuerschaltung (25) vorgeschaltete Sensorschaltung vorgesehen ist, die eine Abweichung vom erlaubten Betriebszustand der Steuerschaltung oder einer Schaltungskomponente (2, 3, 4, 5) erfaßt und als Reaktion auf eine Abweichung des erlaubten Betriebszustandes das Freigabesignal (53) an die erste Öffnungsstufe (26, 27, 28, 29) zur selbsttätigen Aktivierung der Ansteuerschaltung (25) ausgibt.

4. Elektronische Chipkarte mit einer Schaltungsanordnung nach einem der Ansprüche 1 bis 3, wobei die schaltungsanordnung auf einem Halbleiterchip innerhalb eines kartenkörpers der elektronischen Chipkarte untergebracht ist.

## Claims

1. Circuit arrangement having a number of electronic circuit components (2, 3, 4, 5) whose operating state can be put into an erasure state, in which the data content of the respective circuit component (2, 3, 4, 5) adopts a logic zero value, using a predetermined control or data signal (6, 7, 8, 9) which can be applied to the circuit component (2, 3, 4, 5), where,
for the purpose of actuating all the circuit components (2, 3, 4, 5) at successive times, an actuating circuit (25) which operates autonomously after triggering and has a number of turn-on stages (26, 27, 28, 29) connected in series with one another which corresponds to the number of circuit components (2, 3, 4, 5) is provided, each turn-on stage (26, 27, 28, 29) can be activated or driven by a turn-on signal (42, 43, 44, 45), generated by the turn-on stage (26, 27, 28, 29) arranged immediately upstream, for outputting a control signal to the associated circuit component, and the turn-on stage (26, 27, 28, 29) for its part outputs a turn-on signal (42, 43, 44, 45), when the associated circuit component (2, 3, 4, 5) has been actuated, for actuating or activating the turn-on stage (26, 27, 28, 29) arranged immediately downstream,
**characterized in that**
each turn-on stage comprises a gate circuit comprising an enable switch (47, 48, 49, 50) which is turned off by means of an enable signal on an enable signal line (52) when the enable signal has the logic "one" level, and which is on when the enable signal has a logic "zero" level,
a switching transistor (30, 31, 32, 33) having a respective control connection (34, 35, 36, 37) which is connected to the enable switch, and
a driver (38, 39, 40, 41) which actuates the control connection of the switching transistor and turns on the switching transistor in order to actuate the circuit component (2, 3, 4, 5) in question when there is a driver signal of logic "one" at an input of the driver and turns off the switching transistor when there is a driver signal of logic "zero" at the input of the driver, and
the switching transistor, when it is turned on, outputs a turn-on signal which is used to control resetting or erasure of the data content of the circuit component to the logic value "zero", and then a driver signal is output to the input of the driver in the turn-on stage arranged downstream, said driver signal being used to activate this turn-on stage.

2. Circuit arrangement according to Claim 1, in which the electronic circuit components (2, 3, 4, 5) each comprise a semiconductor memory apparatus of the random access type which is formed on a semiconductor substrate and has a group of memory cells,
a data bus (20) having data lines (DB [0], DB [1], DB [2], DB [3], DB [4], DB [5], DB [6], DB [7]) is provided,
an address decoder (14) for actuating the memory cells for the purpose of writing and reading 8-bit data (data(0), data(1), data(2), data(3), data(4), data(5). data(6), data(7)), which are on the data bus, in a data input/output circuit (19) as often as desired is provided and a regulating circuit (55) is provided which has
NOR gates (56, 57) having inputs and outputs, to whose inputs the data lines of the data bus (20) are connected,
a NAND gate (58) having inputs and an output, whose inputs are coupled to the outputs of the NOR gates (56, 57),
an invertor (59), whose input side has the enable signal applied to it, and
a further NOR gate (60) having inputs and an output, whose inputs are coupled to the output of the invertor (59) and to the output of the NAND gate (58) and whose output is coupled to the address decoder (14) via a line (61), so that the actuating circuit (25) is briefly turned off when a data line in the data bus (20) adopts the logic "one" value and hence a signal having the logic "zero" value is generated at the output of the further NOR gate (60).

3. Circuit arrangement according to Claim 1 or 2, in which
a sensor circuit which is associated with a control circuit, provided in the circuit arrangement (1), for electronically controlling one or more circuit components (2, 3, 4, 5) and is connected upstream of the actuating circuit (25) is provided which detects any deviation from the permitted operating state of the control circuit or of a circuit component (2, 3, 4, 5) and, as a reaction to a deviation in the permitted operating state, outputs the enable signal (53) to the first turn-on stage (26, 27, 28, 29) for the purpose of autonomously activating the actuating circuit (25).

4. Electronic chip card having a circuit arrangement according to one of Claims 1 to 3, where the circuit arrangement is accommodated on a semiconductor chip within a card body of the electronic chip card.

## Revendications

1. Circuit comportant plusieurs composants de circuit électroniques (2, 3, 4, 5) dont l'état de fonctionnement peut passer, au moyen d'un signal de commande ou de données (6, 7, 8, 9) prédéterminé à appliquer au composant de circuit respectif (2, 3, 4, 5), dans un état d'effacement dans lequel le contenu de données du composant de circuit (2, 3, 4, 5) prend la valeur logique nulle, dans lequel,
pour la commande successive de tous les composants de circuit (2, 3, 4, 5), il est prévu un circuit de commande (25) qui travaille automatiquement après son déclenchement et qui a un nombre d'étages d'ouverture (26, 27, 28, 29) branchés en série les uns après les autres qui correspond au nombre des composants de circuit (2, 3, 4, 5), dans lequel chaque étage d'ouverture (26, 27, 28, 29) peut être activé ou actionné par un signal d'ouverture (42, 43, 44, 45) qui est produit par l'étage d'ouverture (26, 27, 28, 29) monté immédiatement du côté amont et qui est destiné à la sortie d'un signal de commande vers le composant de circuit associé et dans lequel l'étage d'ouverture (26, 27, 28, 29) délivre pour sa part, après une commande réussie du composant de circuit associé (2, 3, 4, 5), un signal d'ouverture (42, 43, 44, 45) pour la commande ou l'activation de l'étage d'ouverture (26, 27, 28, 29) monté immédiatement du côté aval,
**caractérisé par le fait que**
chaque étage d'ouverture comprend un circuit à portes logiques constitué
d'un interrupteur de libération (47, 48, 49, 50) qui est bloqué par l'intermédiaire d'un signal de libération appliqué à une ligne de signal de libération (52) dans la mesure où le signal de libération a le niveau logique "un" et qui est conducteur pour un niveau logique "zéro" du signal de libération,
d'un transistor de commutation (30, 31, 32, 33) avec une borne de commande respective (34, 35, 36, 37) qui est reliée à l'interrupteur de libération, et
d'un élément d'attaque (38, 39, 40, 41) qui commande la borne de commande du transistor de commutation et qui, pour un signal d'attaque logique "un" à une entrée de l'élément d'attaque, ouvre le transistor de commutation pour la commande du composant de circuit concerné (2, 3, 4, 5) et, pour un signal d'attaque logique "zéro" à l'entrée de l'élément d'attaque, bloque le transistor de commutation, et
le transistor de commutation, lorsqu'il est ouvert, fournit un signal d'ouverture avec lequel une remise à zéro ou un effacement du contenu de données du composant de circuit à la valeur logique "zéro" est commandé puis il fournit à l'entrée de l'élément d'attaque de l'étage d'ouverture suivant un signal d'attaque avec lequel cet étage d'ouverture est activé.

2. Circuit selon la revendication 1, dans lequel
les composants de circuit électroniques (2, 3, 4, 5) comprennent chacun un dispositif de mémoire à semi-conducteurs qui est conçu sur un substrat semi-conducteur et qui est du type à accès aléatoire avec un groupe de cellules de mémoire,
il est prévu un bus de données (20) avec des lignes de données (DB [0], DB [1], DB [2], DB [3], DB [4], DB [5], DB [6], DB [7]),
il est prévu un décodeur d'adresse (14) pour la commande des cellules de mémoire pour l'écriture et la lecture, se produisant un nombre quelconque de fois, de données de 8 bits (Daten(0), Daten(1), Daten(2), Daten(3), Daten(4), Daten(5), Daten(6), Daten(7)), appliquées au bus de données, d'un circuit d'entrée/sortie de données (19) et
il est prévu un circuit de régulation (55) qui comporte des portes NOR (56, 57) avec des entrées et des sorties, aux entrées desquelles se trouvent les lignes de données du bus de données (20),
une porte NAND (58) avec des entrées et une sortie, dont les entrées sont couplées aux sorties des portes NOR (56, 57),
un inverseur (59) auquel le signal de libération est appliqué côté entrée, et
une autre porte NOR (60) avec des entrées et une sortie, dont les entrées sont couplées à la sortie de l'inverseur (59) et à la sortie de la porte NAND (58) et dont la sortie est couplée par l'intermédiaire d'une ligne (61) au décodeur d'adresse (14) de telle sorte que le circuit de commande (25) est brièvement coupé lorsqu'une ligne de données du bus de données (20) prend la valeur logique "un" et donc lorsqu'un signal avec la valeur logique "zéro" est produit à la sortie de l'autre porte NOR (60).

3. Circuit selon la revendication 1 ou 2, dans lequel il est prévu un circuit capteur qui est associé à un circuit de commande prévu dans le circuit (1) pour la commande électronique d'un ou plusieurs composants de circuit (2, 3, 4, 5), qui est branché du côté amont du circuit de commande (25), qui détecte un écart par rapport à l'état de fonctionnement autorisé du circuit de commande ou d'un composant de circuit (2, 3, 4, 5) et qui fournit en réaction à un écart par rapport à l'état de fonctionnement autorisé le signal de libération (53) au premier étage d'ouverture (26, 27, 28, 29) pour l'activation automatique du circuit de commande (25).

4. Carte à puce électronique comportant un circuit selon l'une des revendications 1 à 3, dans laquelle le circuit est placé sur une puce à semi-conducteurs à l'intérieur d'un corps de carte de la carte à puce électronique.
